# EUROPEAN PATENT SPECIFICATION

(11) **EP 4 564 435 B1**
(45) Date of publication and mention of the grant of the patent: **28.01.2026**
(21) Application number: 23213341.3
(22) Date of filing: 30.11.2023
(51) Int. Cl.: H10H 29/14, H10H 20/01, H10H 20/815, H10H 20/817

(54) **SEMICONDUCTOR DEVICE COMPRISING MICROLED STRUCTURES**
HALBLEITERBAUELEMENT MIT MIKRO-LED-STRUKTUREN
DISPOSITIF SEMI-CONDUCTEUR COMPRENANT DES STRUCTURES DE MICRO-DEL

(43) Date of publication of application: 04.06.2025
(73) Proprietor: Hexagem AB, 223 63 Lund (SE)
(72) Inventor: BJÖRK, Mikael, 223 63 Lund (SE); HEURLIN, Magnus, 223 63 Lund (SE); SAMUELSON, Lars, 223 63 Lund (SE)
(74) Representative: Neij & Lindberg AB

(56) References cited:
- WO-A1-2020/187986
- US-A1- 2023 155 060

## Description

### Technical Field

The technology relates to the field of semiconductor devices, specifically for microLEDs (micro light-emitting diodes) used in display and lighting applications. This field focuses on improving the efficiency, performance, and manufacturing processes of microLEDs. The proposed solution is particularly related to such semiconductor devices, and methods of their manufacture, configured to obtain controlled emission wavelength.

### Background

MicroLEDs have emerged as a promising technology for high-resolution displays in various applications, such as augmented reality (AR), virtual reality (VR), mixed reality (MR), smartwatches, and head-up displays (HUDs). These applications require small pixel sizes, typically below 10 µm, to achieve high resolution and compact form factors. The use of microLEDs offers several advantages over competing technologies, such as liquid crystal displays (LCDs) and organic light-emitting diodes (OLEDs), including higher brightness, longer lifetime, and lower power consumption.

However, there are several challenges associated with the fabrication and performance of microLEDs at small pixel sizes. One significant issue is the drastic loss of external quantum efficiency as pixel size decreases. This efficiency loss is mainly due to increased influence of side-wall damages caused by dry etching. As a result, the development of efficient microLEDs with sub-10 µm pixel sizes remains a challenge. The other issue is the microLEDs emitting red light, where both nitride microLEDs and AlInGaP ones are not satisfying in terms of efficiency or brightness.

Another challenge in the fabrication of microLEDs is the assembly of red, green, and blue (RGB) pixels for high-resolution displays. Currently, the three colours are fabricated on separate wafers using epitaxial methods and need to be picked out of those wafers and placed on the backplane/driving circuits of the display to build up the array of RGB pixels. Various techniques exist to accomplish this, many of which are not yet technologically mature. To date, no pick and place methods can successfully be used in production to assemble displays having pixel sizes below 10 µm.

For small displays, like AR/VR/MR, smartwatches, etc., a possibility is to bond the LED wafers directly to Si CMOS active drive circuitry. This still requires the assembly of all three colours into RGB pixels. For pixel sizes above 10 µm, this can be achieved through several approaches, including pick and place methods, mechanical stacking of all three colour sources on top of each other, or multi-junction epilayers connected via e.g., tunnel junctions during epitaxy. However, these approaches are not suitable for pixel sizes below 10 µm.

Several approaches have been proposed to address these challenges, such as direct growth of red, green, and blue LEDs on the same epiwafer, i.e., a semiconductor wafer having a common growth layer, so that pick and place mass transfer can be avoided and instead a single step wafer bonding could be used to attach the LEDs to the CMOS chips. However, a technology is still missing to accomplish an RGB epiwafer with pixel sizes below 10 µm and as small as sub-1-µm with external quantum efficiencies in the double-digit range for all three colours, and to obtain controlled emission wavelength.

WO 2020/187986 A1 and US 2023/155060 A1 disclose semiconductor devices comprising microLED structures grown on top of semiconductor platelets according to the prior art.

### Summary

The proposed solution relates to devices and methods as outlined in the independent claims. Further aspects and features are outlined below, and at least partly set out in the dependent claims.

According to a first aspect of the disclosure, a semiconductor device is provided. The semiconductor device comprises an epiwafer and a plurality of InGaN platelets, each InGaN platelet being monolithically grown on the epiwafer and being configured with a top c-plane surface. An upper mask layer is provided with mask apertures over the InGaN platelets, wherein said mask apertures have a width which is smaller than said top c-plane surface. A plurality of microLED structures is comprised, where each microLED structure comprises a quantum well (QW) layer, wherein each microLED structure is grown on the top c-plane surface in one of said mask apertures.

According to a second aspect, a microLED device is provided, comprising a semiconductor device according to the first aspect, and a driver circuit. The driver circuit is connected by p-contacts to respective top portions of each microLED structure and by an n-contact to a base side of the epiwafer, for generating light emission from the respective microLED structure.

According to a third aspect, a method of fabricating a semiconductor device is provided, comprising:
forming InGaN platelets monolithically grown on an epiwafer, wherein each InGaN platelet has a top c-plane surface;
configuring an upper mask layer over the truncated InGaN platelets;
forming mask apertures in the upper mask over the top c-plane surfaces, wherein said apertures have a width which is smaller than said top c-plane surface; and
growing, from each mask aperture, a microLED structure comprising a QW layer over the top c-plane surface.

The proposed solution is thus based on preparing InGaN platelets for forming microLEDs, wherein the microLEDs are grown on the InGaN platelets. Specifically, by applying an upper mask layer with apertures over the InGaN platelets, the microLEDs may be formed by monolithic growth from the upper c-planes of the InGaN platelets.

The proposed solution is particularly suitable for manufacture of semiconductor devices which comprise a large number microLEDs over a surface, such as for display technology, and allows for semiconductor devices to be made comprising a large quantity of microLEDs by monolithic growth. This is significantly more efficient than pick and place technology, where the microLEDs are formed separately.

Moreover, even when microLEDs are grown on a common epiwafer, polishing or other type of material removal process of a surface carrying a multitude of platelets for microLED manufacture is typically challenging to carry out with consistent quality over the surface. Apart from the risk of damage, this may result in unwanted variation in height in the platelets. Where the platelets are pyramidic in shape, i.e., with slanted side facets, the exposed c-planes of the platelets may vary in size. This may result in difference in growth from one platelet to another, even under the same growth conditions. As a consequence, emission wavelength may vary.

By means of the proposed solution, with selected configuration of the mask apertures, microLEDs may be grown in a common process which does not require InGaN material removal between manufacture of microLEDs configured for different emission wavelength. Rather, the aperture width of the mask aperture is configured to promote growth of microLED structures with selected emission wavelength.

The proposed solution represents several advancements over the prior art due to the use of InGaN platelets, which act as pseudo substrates with optimal In composition which reduces strain and enhances efficiency in the LED structure, in combination with patterning which allows for wavelength tuning of the microLED structures.

### Brief Description of the Drawings

Fig. 1 schematically illustrates three epitaxially grown semiconductor devices, in the form of hexagonal InGaN pyramids, based on which various embodiments of the proposed solution may be obtained.
Figs 2A to 2E schematically illustrates an example of various steps of a process flow for manufacture of a microLED structure on an epiwafer, according to the proposed solution.
Fig. 3A schematically illustrates a semiconductor device according to an example of the proposed solution, where microLED structures for different emission wavelengths are grown on different InGaN platelets on the same epiwafer.
Fig. 3B schematically illustrates a semiconductor device according to another example of the proposed solution, where microLED structures for different emission wavelengths are grown on a common InGaN platelet on an epiwafer.
Fig. 4A schematically illustrates a cross-sectional view of aperture configuration over InGaN platelets, for growth of microLED structures corresponding to the example of Fig. 3A.
Fig. 4B schematically illustrates a cross-sectional view of aperture configuration over InGaN platelets, for growth of microLED structures corresponding to the example of Fig. 3B.
Fig. 5A shows a top view of an arrangement of contacts on the semiconductor device for attachment to a driver circuit according to one example, based on the embodiment described with reference to Fig. 3A.
Fig. 5B schematically illustrates a side view showing the contacts to the semiconductor device according to one example.
Fig. 5C schematically illustrates a semiconductor device, in which the semiconductor device is connected to a driver circuit for generating emission of RGB light, according to one example.
Fig. 5D schematically illustrates an alternative to the example of Fig. 5C, where the growth layer is replaced by a deposited transparent conductive layer.
Fig. 6A shows a top view of an arrangement of contact on the semiconductor device for attachment to a driver circuit according to one example, based on the embodiment described with reference to Fig. 3B.
Fig. 6B schematically illustrates a side view showing the contacts to the semiconductor device according to one example.
Fig. 6C schematically illustrates a semiconductor device, in which the semiconductor device is connected to a driver circuit for generating emission of RGB light, according to one example.
Fig. 6D schematically illustrates an alternative to the example of Fig. 6C, where the growth layer is replaced by a deposited transparent conductive layer.
Fig. 7 schematically illustrates hexagonal InGaN RGB platelet array design according to one embodiment.
Fig. 8A illustrates a first example of an RGB pixel based on the pattern of Fig. 7.
Fig. 8B illustrates a second example of an RGB pixel based on the pattern of Fig. 7.

Fig. 9 shows an exemplary pixel array layout for a display based on the example of Fig. 8A.

### Detailed Description

The detailed description set forth below provides information and examples of the disclosed technology with sufficient detail to enable those skilled in the art to practice the disclosure.

Ternary InGaN alloys are widely used as active layers (or quantum wells) in nitride LEDs and laser diodes. The thickness of the InGaN active layers is usually no more than 3 nm, mainly in order to limit impacts of quantum confined Stark effect (QCSE) which reduces the spatial overlap between the electron and hole wave functions in the quantum wells. Another reason is that the crystal quality of InGaN can deteriorate quickly when the layer is grown thick, partly due to a large miscibility gap between GaN and InN but mainly due to strain effects from the growth on mismatched substrates. However, the prospect of thick and relaxed InGaN films is highly desirable, for the use as a substrate for nitride optoelectronic devices where high indium-content InGaN active layers are needed.

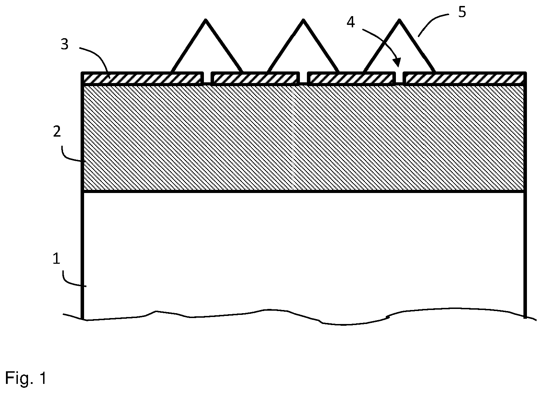

Fig. 1 shows three epitaxially grown semiconductor structures in the form of hexagonal InGaN pyramids, which can be used as a basis for various embodiments of the proposed solution. This drawing illustrates a semiconductor structure which may be fabricated and used as a starting structure for fabricating the InGaN platelets according to the proposed solution. A base substrate 1 of e.g., sapphire or Si, is provided with one or more layers of c-oriented GaN as growth layer 2, such as a (0001)-oriented GaN film. A mask layer 3 of e.g., SiNₓ is formed on top of the GaN layer. Holes (or openings/apertures) 4 are provided in the mask layer. The holes 4 may be manufactured by means of various types of lithography, such as EBL (electron beam lithography), nanoimprint, DUV (Deep UltraViolet) lithography, etc. The holes 4 may be very narrow, e.g., with a diameter of 20-200 nm, 50-150 nm, or 60-100 nm. Growth of a seed of a first III-nitride material, such as GaN, may optionally be performed. In a subsequent step, hexagonal pyramids 5 of InGaN are epitaxially grown over the holes, from the growth layer (optionally from the seeds). The growth takes place with gallium and indium species primarily diffusing from the SiN mask surface to the holes, without any nucleation on the mask surface. This way, growth of InGaN pyramids with an indium composition up to 20% has been realized, as determined by photoluminescence (PL) measurements. The growth of the InGaN pyramids may be carried out with selective doping, such that negatively doped n-InGaN pyramids 5 are obtained. Various examples and aspects related to the prefabrication of the structure of Fig. 1 are disclosed in WO2020187986A1, which is incorporated herein by reference.

The hexagonal InGaN pyramids with a diagonal base size of several hundred nanometers, such as >400 nm, may be used. These pyramids have { 101 1̅}̅ side facets (s-planes), and occasionally a small flat (0001) top facet (c-plane). Each of the pyramids is a homogeneous InGaN semiconductor structure. The InGaN pyramid may be made of InGaN (n-InGaN) with an Indium concentration of about 10% or 8-12%.

The pre-fabrication step of epitaxial growth from the mask holes results in the InGaN pyramids being free, or substantially free, from dislocations. As a result, emission non-uniformity caused by dislocations between pixels (individual semiconductor devices) is avoided. This contributes positively to obtain high quantum efficiency, such as more than 10%. In addition, a very thin GaN buffer/growth layer 2 may be used, e.g., below 1 µm, which results in very low wafer bow. This provides the benefit of high yield processing. In alternative embodiments, the growth layer may be other than GaN, such as Si.

Various aspects of the proposed solutions are based on creating InGaN platelets configured for further growth of microLEDs, each configured to emit light of one of red, green and blue. Each such InGaN platelet is in some embodiments processed from an array of InGaN pyramids which are substantially identical, by being concurrently grown from respective mask holes in an epitaxy process.

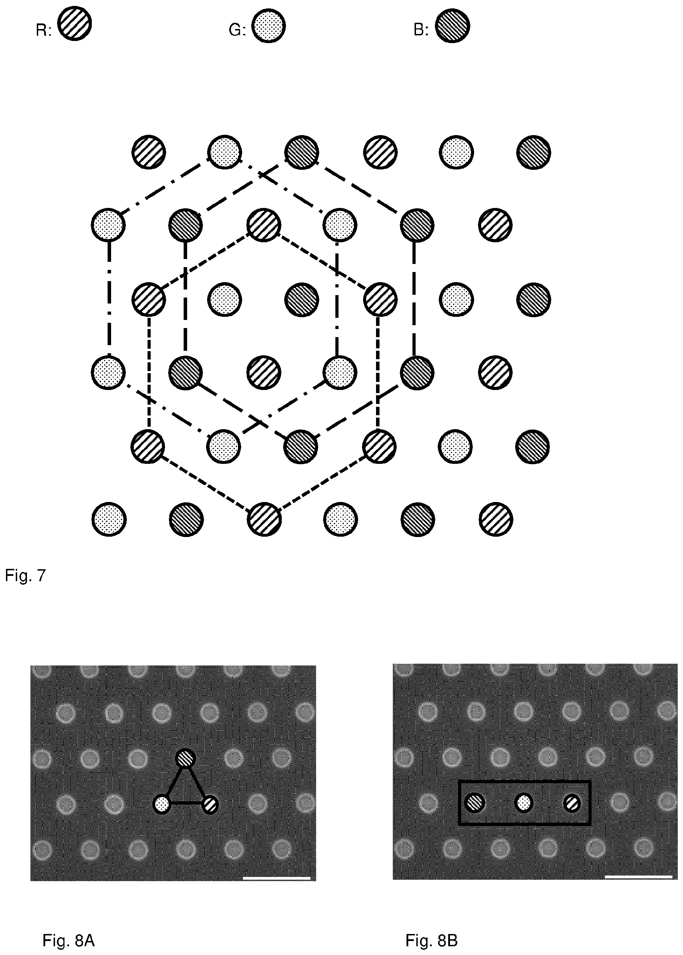

According to some examples, the InGaN platelets are arranged/grown in a first trigonal pattern on the carrier, wherein each InGaN platelet has six neighbour InGaN platelets at the same distance. This way, uniformity in growth of the InGaN pyramids, based on which the InGaN platelets are formed, is obtained. In such embodiments, an RGB triplet may e.g., be defined in a straight line, or in a triangular arrangement as shown in Fig. 8A and Fig. 8B. In other examples, the InGaN platelets are arranged in a quadratic or rectangular pattern. In such embodiments, an RGB triplet may e.g., be defined in a straight line or in an L-shape.

Use of epitaxially grown InGaN pyramids, grown from small holes to a common growth layer, provides advantages of high crystal quality and high production efficiency of the InGaN platelets.

The proposed solution includes a method for fabrication of a semiconductor device comprising microLED structures configured for red, green, and blue (RGB) emission on the same carrier. Each microLED structure is grown on an InGaN platelet grown on a common semiconductor substrate, herein also referred to as epiwafer. Each InGaN platelet is thus configured to carry one or more microLED structures, which are connectable to a driver circuit.

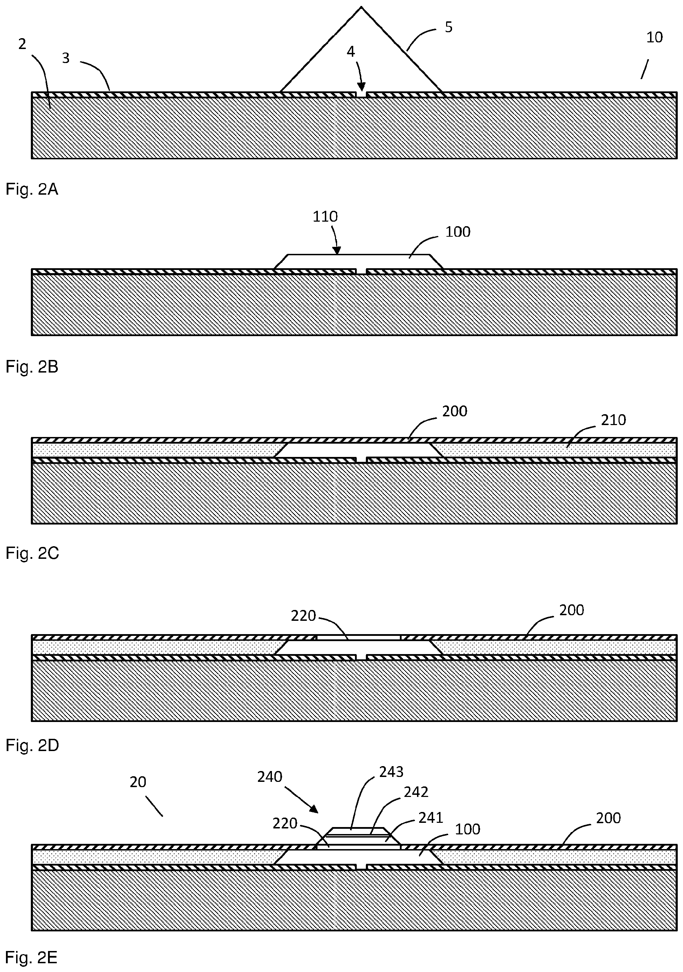

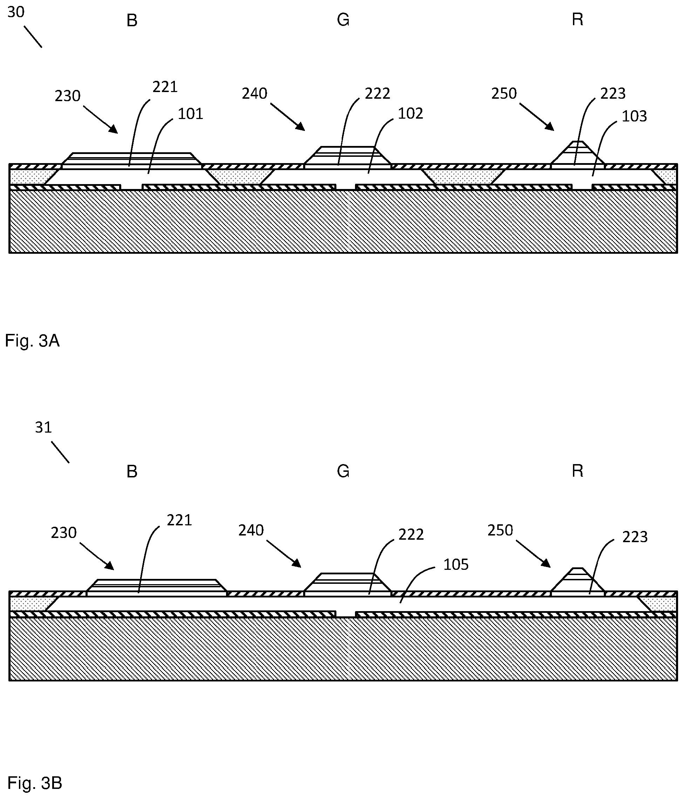

Figs 2A-2E presents various stages of a first example of a process flow for making a semiconductor device 20 comprising a plurality of microLED structures on the same epiwafer 10 according to the proposed solution. For the sake of simplicity, these drawings only show a single microLED structure 240. Further features and examples related to the semiconductor device comprising a plurality of microLED structures on the same epiwafer 10, such as microLED structures for red, green, and blue light emission, will be discussed with reference to Figs 3A and 3B below. It shall be noted, though, that the semiconductor device comprising a plurality of microLED structures may comprise microLED structures configured for only one and the same emission wavelength, or configured for two, three or more than three different wavelengths.

The process includes, or succeeds, epitaxial growth of InGaN pyramids 5 through mask openings 4 of the epiwafer 10, wherein the structure of Fig. 2A is obtained. The InGaN pyramids may have a certain configured indium content, such as 8-12%, e.g., 10%. This may correspond to Fig. 1. In this context, it may be noted that the epiwafer 10 (or carrier) may comprise at least the mask layer 3, whereas the underlying growth layer 2, used for growing the InGaN pyramids through the mask holes, may be removed or thinned after finalizing the semiconductor device.

With reference to Fig. 2B, the process may involve truncation of the InGaN pyramids 5 to form truncated InGaN pyramids 100, i.e., InGaN platelets 100. In the context of the proposed solution, truncation may be obtained using one or more of various types of processes for material removal or redisposition to obtain a truncated pyramid shape. Truncation involves material removal, e.g., by back-etching, annealing or polishing, such as chemical mechanical polishing (CMP). After truncation, top c-plane surfaces 110 of the InGaN platelets 100 are formed at a certain elevation over the carrier, such as over a top surface of the mask layer 3. In some examples, this involves truncation of all pyramids to leave respective base layers of a common height over the carrier top surface (of the mask layer 3), such as 20-500 nm, or 80-120 nm. The InGaN platelets 100 shall desirably be identical, and each InGaN platelet 100 may have a diameter (point-to-point of its hexagonal footprint) of 150 nm to 2 µm, or 500-1000 nm. The lateral distance between the InGaN platelets is determined by the pitch between the mask holes 4 and for how long time they have been grown, and the drawings herein are provided to be explanatory rather than to scale. Optionally, additional InGaN growth of an InGaN surface layer, or buffer layer, may subsequently be carried out over the respective InGaN platelet 100, acting as a repair layer to provide surface improvement of the upper c-plane surface before QW growth, and optionally also to remove any curved dome shape resulting from polishing. In other examples, as will be described with reference to Fig. 2E, buffer layer growth is carried out only on a limited, masked, part of the exposed c-planes of the InGaN platelets.

Fig. 2C illustrates a process step, where an upper mask layer 200 has been provided over the epiwafer 10, covering the InGaN platelets 100. The upper mask layer 200 may be formed of an inert mask material such as SiOx, SiNx or AlOx. The upper mask layer may have a thickness of about 30 nm, or in the range of 5-200 nm. In some examples, a filler material 210 may be provided to fill out the space between the InGaN platelets 100, prior to upper mask layer formation. In some examples, the filler material 210 may be provided already at the stage of Fig. 2A (and present also in Fig. 2B), thus being subjected to the same truncation step as the InGaN material of the pyramids 5.

Fig. 2D illustrates forming of mask apertures 220 in the upper mask layer 200. In some examples, this may be carried out by lithography. Such a process may comprise spinning resist over the upper mask layer 200, exposing the resist in a lithography machine to form an exposure pattern corresponding to the intended aperture configuration, removing the exposed/non-exposed resist (dependent on process), etching holes through the upper mask layer 200 where the resist was removed, and removing the remaining resist. As a result, the upper mask layer 200 is provided with apertures 220 formed over the top c-plane surfaces 110 of the InGaN platelets 100, wherein said mask apertures 220 have a width which is smaller than said top c-plane surface.

Fig. 2E illustrates the semiconductor device 20 after growth of a microLED structure 240. The microLED structure 240 is grown on the top c-plane surface 110 in the mask aperture 220 and comprises QW layers 242. Growth of the microLED structure 240 may be carried out in a MOCVD chamber. The QW layers 242 may comprise an n-type InGaN buffer, InGaN QW, a GaN, InGaN or AlGaN electron blocking layer and a p-InGaN layer. The microLED structure 240 may further comprise an InGaN surface layer, or buffer layer, 241 which is first grown on the c-plane surface 110 in the mask aperture 220. This layer 241 may partly act as a repair layer to provide surface improvement of the upper c-plane surface before QW growth, and optionally also to remove any curved dome shape resulting from polishing. The microLED structure 240 may further comprises a top InGaN layer 243 grown on the QW layer 242.

Due to the nature of the crystal facets that define the hexagonal platelets the growth rate on the side facets (s-planes) is lower than on the top c-plane i.e., the growth is anisotropic. This means that the aperture 220 will set the lateral size of the QW layers. For exemplary growth conditions, the difference in the growth rate on the top c-plane and the s-planes is around 30:1.

With reference mainly to Figs 2D and 2E, the apertures 220 define surface areas of further growth on the respective InGaN platelet 100. In this context, it shall be noted that the size of the exposed part of the c-plane of the InGaN platelets 110 will affect the further growth. The apertures 220 can be seen as a collection site for material that lands on the surface of the aperture and on the surface of the upper mask layer 200 which is halfway between that aperture and the next adjacent one (material that lands between apertures will diffuse/move to a nearby aperture). If the distance between apertures remains the same but the aperture gets smaller, more material will be collected per "open aperture area". This will result in a higher growth rate and thus more growth in a smaller aperture. This also leads to a higher In composition. The emission from a QW will be more towards the red for a smaller aperture both because of higher In composition and because the QW layer will be thicker resulting in smaller quantization energy of carriers and thus longer wavelength compared to a larger aperture.

If QW layer growth is carried out on a structure as shown in Fig. 2B, the surface area of the c-plane 110 of the respective InGaN platelet 100 will be determined by the height of the truncated pyramid/cone, due to the slanted shape of the side facets. However, controlling the height of the InGaN platelets 100 is very challenging when it is determined by truncation, i.e., by material removal, such as by CMP. By way of example, a controlled and consistent height of a plurality of InGaN platelet is very difficult to obtain across a 6" (150 000 000 nm) epiwafer 10. This is further complicated by the fact that the epiwafer 10 normally is not totally flat but can have a built-in bow of several 1000 nm. This bow cannot be fully compensated for in the truncation process which makes it difficult to control the height with desired accuracy. As a result, emission wavelength from the respective microLED would differ by 10ths of nanometers, which for many applications is not sufficient and which is clearly detectable by the human eye.

In contrast, and in accordance with the proposed solution, where the exposed part of the c-plane surface area 110 of the respective InGaN platelet 100 is determined by the apertures 220, a much more controlled growth area for QW growth is obtained. The aperture size (width) can be done with high precision and low spread in size, as controlled in the lithography step. As a result, lower variation in emission wavelength is obtained throughout a plurality of microLEDs grown over an area of the epiwafer 10. Tests made by the inventors indicate a spread in average emission wavelength of less than 5 nm between microLED structures 240 grown on different platelets 100.

Two different embodiments of semiconductor devices comprising a plurality of microLED structures configured for emission of different wavelengths will now be described by examples, with reference to Figs 3A and 3B.

Fig. 3A shows one example of an embodiment of a semiconductor device 30 wherein a single mask aperture is configured over each InGaN platelet, wherein a single microLED is configured on each InGaN platelet. The drawing shows InGaN templates 101, 102, 103 configured by growth from the same growth layer. The InGaN platelets are substantially identical, whereas the respective height, and thus the size of the respective top c-plane surface, may differ due to material removal for forming the truncated pyramid shape. Mask apertures 221, 222, 223 are formed in the upper mask layer over the respective InGaN platelet 101, 102, 103. Specifically, the mask apertures 221, 222, 223 are configured with different width, to promote growth of microLED structures 320, 240, 250 having different emission wavelength. Resulting emission wavelength decreases with increasing aperture width. In other words, the aperture width correlates with emission wavelength from the respective microLED structure, in the order red-green-blue. By means of proper design of the aperture widths, microLED structures for red (R) 250, green (G) 240, and blue (B) 230 emission are configured on each InGaN platelet. Specifically, by careful design of the mask apertures, all microLED structures 230, 240, 250 may be grown in a common epitaxial process. This provides for an efficient production process. Emission colour is configured dependent on aperture width, which is controlled by the aperture formation in the lithography step, and QW layers are thereafter grown under the same growth conditions for all microLED structures. It may further be noted that where the respective microLED structure 230, 240, 250 comprises an InGaN buffer layer (see 241 of Fig. 2E), also the indium concentration of that buffer layer may vary dependent on aperture width.

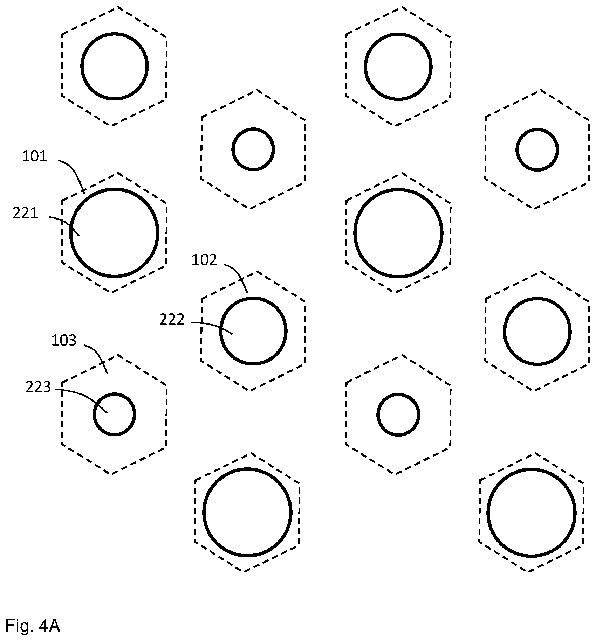

Fig. 4A shows a cross-sectional view through the upper mask layer 200 of an example of the proposed solution, as configured in accordance with Fig. 3A. Herein it is visualized that the c-plane surface (dashed) of the underlying InGaN platelets 101, 102, 103, available for further epitaxial growth of the microLED structures, is limited by the configured apertures 221, 222, 223. The top c-plane surface of the respective InGaN platelet has a hexagonal footprint. In various examples, the respective mask aperture 221, 222, 223 has a substantially circular footprint, though other shapes are possible. The difference in aperture width is also visualized, which promotes growth of MicroLED structures having different emission wavelength.

Fig. 3B shows an example of a second embodiment of a semiconductor device 31, wherein a plurality of mask apertures is configured over each InGaN platelet, of which only one InGaN platelet 105 is shown in the drawing. A plurality of microLED structures 230, 240, 250 is thus configured on each InGaN platelet, formed by epitaxial growth in a common process. Specifically, in some examples, respective microLED structures for red (R) 250, green (G) 240, and blue (B) 230 emission are configured on each InGaN platelet 105.

In such an embodiment, a larger InGaN platelet 105 may be formed, compared to the embodiment of Fig. 3A. By way of example, it may be configured with a height of 100-3000 nm, and a diameter of 2-8 µm.

A further benefit of the embodiment of Fig 3B is that any resulting curved dome shape of the upper surface of the InGaN platelet 105, as caused by truncation, may be less prominent in the respective aperture. This may require less buffer layer growth.

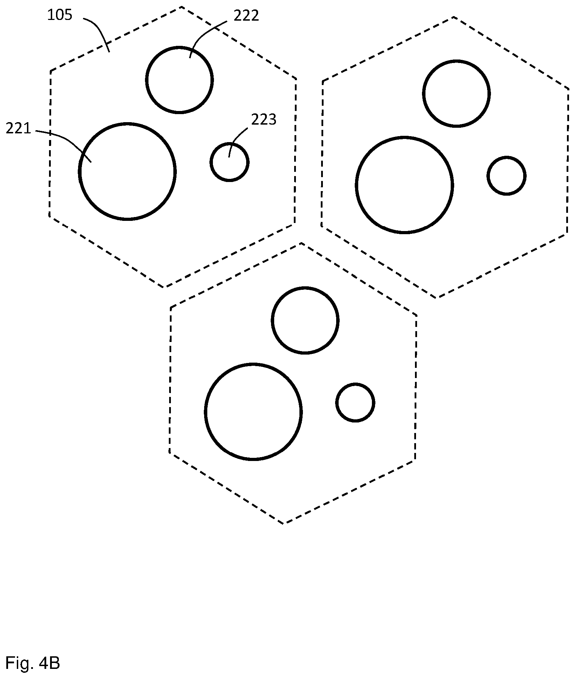

Fig. 4B shows a cross-sectional view through the upper mask layer 200 of an example of the proposed solution, as configured in accordance with Fig. 3B. Herein it is visualized that the c-plane surface (dashed) of the underlying InGaN platelets 105, available for further epitaxial growth of the microLED structures, is limited by the configured apertures 221, 222, 223. The top c-plane surface of the respective InGaN platelet has a hexagonal footprint. In various examples, the respective mask aperture 221, 222, 223 has a substantially circular footprint, which may be beneficial to obtain in a lithographic process, though other shapes are possible. The difference in aperture width is also visualized, which promotes growth of MicroLED structures having different emission wavelength.

While examples are provided herein for typical RGB microLED structures, it should be noted that in other embodiments, microLED structures may be grown for other purposes, such as for IR or UV emission. These may be configured separate from RGB, or in combination with RGB microLED structures. They may further be configured on separate InGaN platelets, corresponding to Fig. 3A, or on a common InGaN platelet as in Fig. 3B.

In various examples, each microLED structure have a truncated pyramid shape terminating in a c-plane connector surface. This provides for suitable connection to a driver circuit. The microLED configured to emit the longest wavelength, i.e., the one grown in the smallest aperture, will grow fastest. The aperture widths and the growth conditions may thus be configured such that the microLED growing in the smallest aperture does not grow to a full pyramid.

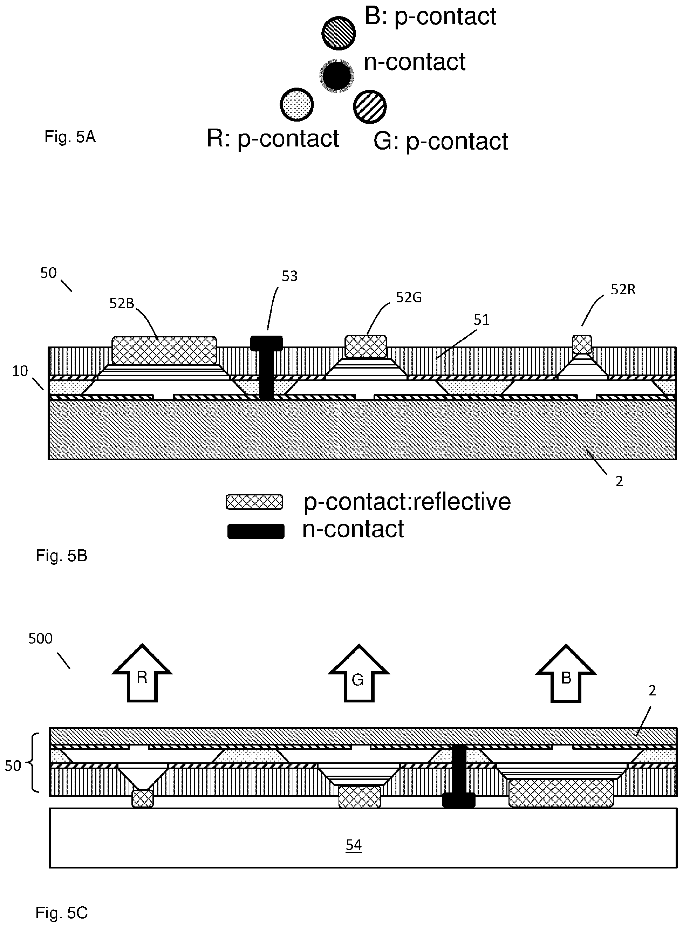

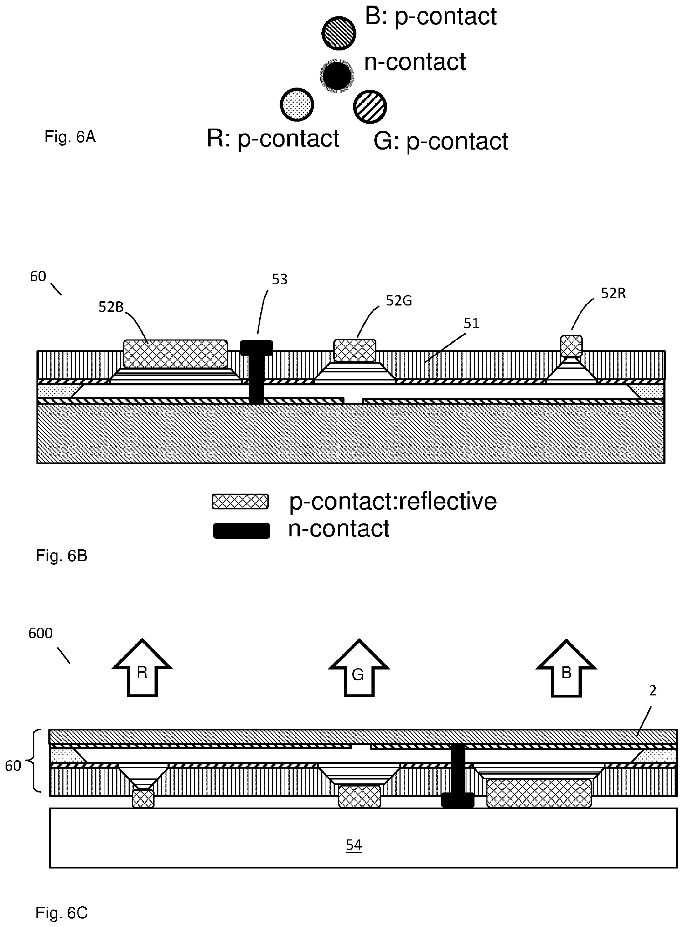

Figs 5A-5D, and Figs 6A-6D, schematically illustrate contacting of the semiconductor device 50, 60 according to various examples of the proposed solution. The embodiments of Figs 5A-5D are based on the embodiment exemplified with reference to Fig. 3A, whereas the embodiments of Figs 6A-6D are based on the embodiment exemplified with reference to Fig. 3B. Where corresponding features are concerned, the same reference numerals are used in Figs 5A-5D and 6A-6D. Where reference signs are not included, reference is made to details highlighted in the other drawings.

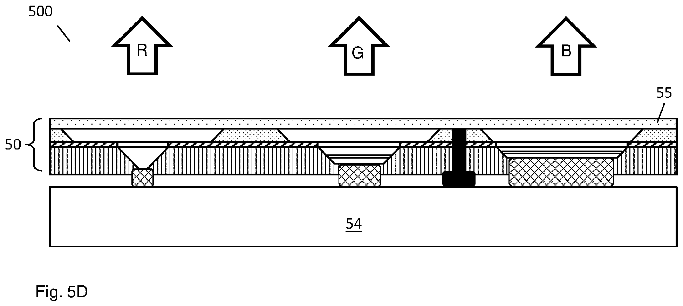

Figs 5A and 5B schematically illustrate an example of the semiconductor device 50 according to the proposed solution, based on the embodiment exemplified with reference to Fig. 3A, whereas Figs 5C and 5D show examples of a microLED device 500 where the semiconductor device 50 is connected to a driver circuit.

Fig. 5A shows a top view of one example of a triangular arrangement of RGB mircoLED structures, where an n-contact is centrally configured in the triangular pixel arrangement. Separate n-contacts to the respective microLED is another option.

Fig. 5B schematically illustrates the semiconductor device 50 according to an example of the proposed solution. As described and exemplified herein, the semiconductor device 50 comprises an epiwafer 10, and a plurality of InGaN platelets 100, each InGaN platelet being monolithically grown on the epiwafer and having a top c-plane surface. An upper mask layer 200 having mask apertures 220 is provided over the InGaN platelets, wherein said mask apertures have a width which is smaller than said top c-plane surface. A plurality of microLED structures, comprising QW layers, is grown on the top c-plane surface in one of said mask apertures. In this example, one microLED is grown on each InGaN platelet. In the drawing, the growth layer 2 still remains, but this layer may be stripped or thinned before or after contacting.

A contact spacer layer 51 may be applied over microLED structures, wherein p-contacts 52B, 52G, 52R to the respective InGaN platelet project through the contact spacer layer 51 and bond to the respective top c-plane surface of the microLED structures. The contact spacer layer 51 is a dielectric layer, which allows for the application of leads (not shown) to the p-contacts over the surface of the microLED device. An n-contact 53 for the group of pixels (or separate contacts) is formed to extend from a surface of the base side of the InGaN platelets to the top side of the semiconductor structure 50, for convenient connection of the driver circuit. The n-contact 53 may be a metal connection, according to the shown example.

Figs 5C and 5D schematically illustrate examples of a microLED device 500 based on the example of Fig. 5B, comprising the semiconductor device 50 according to the proposed solution. The drawing indicates attachment and connection of the semiconductor device 50 to a driver circuit 54. Each microLED structure has a top c-plane surface connectable to the driver circuit 54, by means of the respective connector 52R, 52G, 52B for generating light emission.

The driver circuits 54 are here exemplified by Si CMOS driver circuits. In some examples, thin film active transistor drivers may instead or additionally be used. While the top image of Fig. 5A suggests triangular grouping of RGB pixels with a central n-contact, the lower images show a linear representation for the sake of simplicity. Either is possible.

Where the microLED device 500 is configured to emit light through the base side of the InGaN platelets, the p-contacts 52B, 52G, 52R, connected to the upper c-planes of the respective microLED structure, may be reflective to increase light output.

The base substrate 1 (see Fig. 1) is removed. The original growth layer 2 may, as mentioned, further be thinned or stripped. In the example shown in Fig. 5C, at least a portion of the growth layer 2 remains (potentially after thinning), acting as a lead for connecting the n-connector to the base side of the respective InGaN platelet.

Fig. 5D shows an alternative to the example of Fig. 5C. Here, the growth layer 2 is completely removed, as well as the growth mask 3. A Transparent connector layer 55, such as a Transparent Conducting Oxide (TCO), is deposited to the base surface of the semiconductor device 50, acting as a lead for connecting the n-connector to the base side of the respective InGaN platelet.

The epiwafer 10 of the microLED device 500 thus comprises the InGaN platelets and a transparent conducting layer which may comprises the mask layer 3 and a part of the growth layer 2 or a transparent oxide layer.

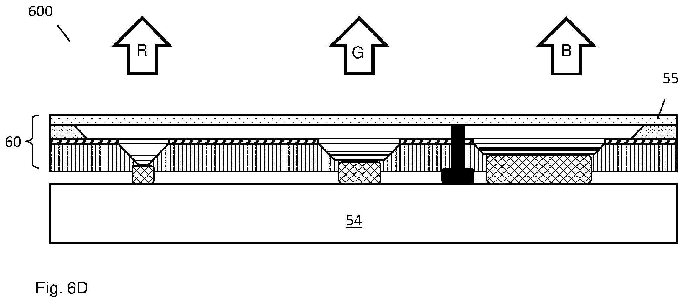

Figs 6A and 6B schematically illustrate another example of the semiconductor device 60 according to the proposed solution, based on the embodiment exemplified with reference to Fig. 3B where more than one microLED structure is configured on a common InGaN platelet, whereas Figs 6C and 6D show examples of a microLED device 600 where the semiconductor device 60 is connected to a driver circuit.

Fig. 6A shows a top view of one example of a triangular arrangement of RGB mircoLED structures, where an n-contact is centrally configured in the triangular pixel arrangement. Separate n-contacts to the respective microLED is another option.

Fig. 6B schematically illustrates the semiconductor device 60 according to an example of the proposed solution, based on the embodiment exemplified with reference to Fig. 3B. As described and exemplified herein, the semiconductor device 60 comprises an epiwafer 10, and a plurality of InGaN platelets 100, each InGaN platelet being monolithically grown on the epiwafer and configured with a truncated pyramid shape with a top c-plane surface. An upper mask layer 200 having mask apertures 220 is provided over the InGaN platelets, wherein said mask apertures have a width which is smaller than said top c-plane surface. A plurality of microLED structures, comprising QW layers, is grown on the top c-plane surface in one of said mask apertures. In this example, three apertures are configured in the upper mask layer over each InGaN platelet. In the drawing, the growth layer 2 still remains, but this layer may be stripped or thinned before or after contacting.

A contact spacer layer 51 may be applied over microLED structures, wherein p-contacts 52B, 52G, 52R to the respective InGaN platelet project through the contact spacer layer 51 and bond to the respective top c-plane surface of the microLED structures. The contact spacer layer 51 is a dielectric layer, which allows for the application of leads (not shown) to the p-contacts over the surface of the microLED device. An n-contact 53 for the group of pixels (or separate contacts) is formed to extend from a surface of the base side of the InGaN platelets to the top side of the semiconductor structure 60, for convenient connection of the driver circuit. The n-contact 53 may be a metal connection, according to the shown example.

Figs 6C and 6D schematically illustrate examples of a microLED device 600 based on the example of Fig. 6B, comprising the semiconductor device 60 according to the proposed solution. The drawing indicates attachment and connection of the semiconductor device 60 to a driver circuit 54. Each microLED structure has a top c-plane surface connectable to the driver circuit 54, by means of the respective connector 52R, 52G, 52B for generating light emission.

The driver circuits 54 are here exemplified by Si CMOS driver circuits. In some examples, thin film active transistor drivers may instead or additionally be used. While the top image of Fig. 6A suggests triangular grouping of RGB pixels with a central n-contact, the lower images show a linear representation for the sake of simplicity. Either is possible.

Where the microLED device 600 is configured to emit light through the base side of the InGaN platelet, the p-contacts 52B, 52G, 52R, connected to the upper c-planes of the respective microLED structure, may be reflective to increase light output.

The base substrate 1 (see Fig. 1) is removed. The original growth layer 2 may, as mentioned, further be thinned or stripped.

In the example shown in Fig. 6C, at least a portion of the growth layer 2 remains (potentially after thinning), acting as a lead for connecting the n-connector to the base side of the respective InGaN platelet.

Fig. 6D shows an alternative to the example of Fig. 6C. Here, the growth layer 2 is completely removed, and also the growth mask 3 is removed in this example. A Transparent connector layer 55, such as a TCO, is deposited to the base surface of the semiconductor device 60, acting as a lead for connecting the n-connector to the base side of the respective InGaN platelet.

The epiwafer 10 of the microLED device 600 thus comprises the InGaN platelets and a transparent conducting layer which may comprises the mask layer 3 and a part of the growth layer 2 or a transparent oxide layer.

Fig. 7 shows an example of microLED RGB array design according to some examples of the proposed solution. Epitaxial growth out of trigonally arranged apertures in the upper mask layer 200, wherein each microLED structure has six neighbour microLED structures at a common distance, leads to very uniform growth conditions resulting in well-controlled compositions.

A hexagonal array is configured for each colour, as indicated in the drawing. The hexagonal pattern provides that the same distance/spacing is configured between all InGaN platelets prepared for the same emission wavelength. This is beneficial for growth uniformity. Specifically, by keeping trigonal symmetry (and centre-to-centre spacing) for red, green, and blue platelet LEDs, colour purity and uniformity across the wafer for each LED colour is very high. This arrangement is particularly suitable for use with the embodiment described with reference to Fig. 3A, where there is a one to one relationship between InGaN platelets and microLED structures.

Fig. 8A shows one example of a pixel group configuration, where a triplet of RGB microLED structures is combined in one pixel group, capable of realizing any colour in the visible spectrum. In this example, a triangular pixel group is configured.

Fig. 8B shows, by way of example, an alternative arrangement of a triplet of RGB microLED structures in one pixel group, capable of realizing any colour in the visible spectrum. In this example, a linear combination is configured.

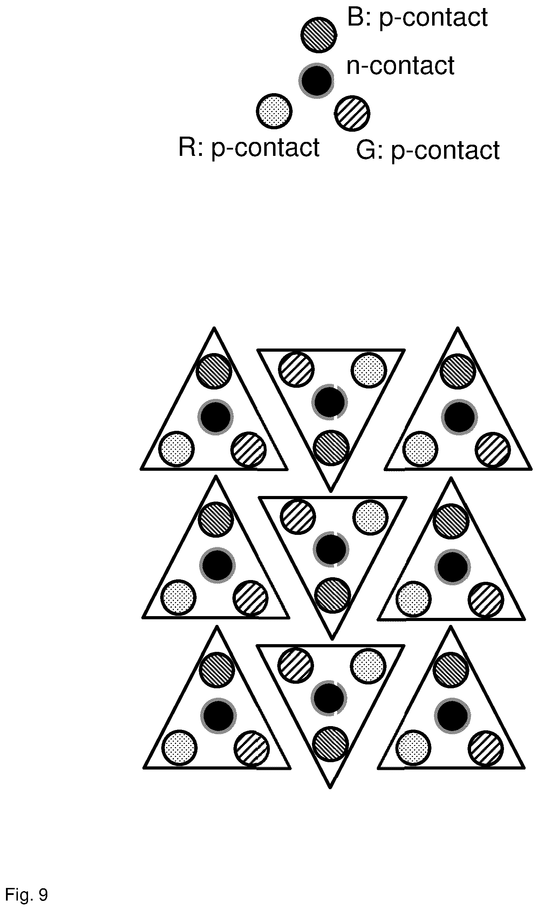

Fig. 9 shows an example of several pixel RGB groups, each comprising a triplet in accordance with the example of Fig. 8A. The pixel array layout demonstrates the arrangement of microLED structures for red, green, and blue light emission in a display application.

The above-described embodiments provide examples of the proposed solution for a semiconductor device for microLEDs and a method of fabricating the same. The disclosed technology minimizes defects in crystal formation and improves external quantum efficiency for microLEDs with sub-10 µm pixel size. It further provides a solution for minimizing emission wavelength variation between microLED structures, epitaxially grown on the same wafer, intended to transmit light of the same wavelength. It should be understood that the specific embodiments described herein are merely illustrative and not intended to limit the scope of the disclosure. Various modifications and adaptations may be made by those skilled in the art without departing from the scope of the disclosure as set forth in the appended claims.

With reference to the description above of the proposed solution and its examples and embodiments, various further related features and examples are outlined below.

The growth of InGaN pyramids through mask openings 4 of the epiwafer 10 enables the formation of InGaN platelets 100 with a specific shape and configuration. This controlled growth process contributes to the overall quality and performance of the resulting microLEDs, as it allows for the formation of InGaN platelets with minimal defects and optimized external quantum efficiency.

The growth mask 3, configured for growing InGaN pyramids, is preferably of a dielectric material such as AlOₓ, SiNₓ, TiN. Holes 4 opened through the dielectric growth mask are preferably placed in a trigonal lattice arrangement, as shown in Figs 9-12, with hole dimensions in the 20-200 nm range and spaced 0.5 - 10 µm apart.

The grown InGaN pyramids 5 are preferably grown as n-type InGaN. The n-type InGaN pyramids may be doped with e.g., Si to a level of 1-5×10¹⁸ cm⁻³.

According to some examples, InGaN pyramids 5 of identical composition are concurrently grown, as n-type InGaN pyramids of certain indium concentration, wherein the pyramids are later processed to obtain separate InGaN platelets.

According to other examples, for the blue LEDs, either GaN or InGaN pyramids with an indium content below 5% (wavelength <380 nm) may be used. For green LEDs, InGaN pyramids with an indium content around 10% (wavelength 420-430 nm) is preferred, and for red LEDs, 18%-20% indium contents (wavelength 480-500 nm) are preferred. Different content/concentration of indium may be obtained by growing the InGaN pyramids in separate processes.

The microLED structures comprise a QW layer, also referred to as active layer, which as such may comprise one or more QWs, such as 3-5 QWs. Each QW of the QW layer may be about 2-3 nm thick. The compositions (i.e., the Indium concentration) for blue, green and red are about 10-15%, 25-27% and 35-40%, respectively. When combining blue, green and red LEDs on the same epiwafer, an electron blocking layer (EBL) of AlGaN with an Al content of 10-25% and a thickness of 10-25 nm may be used. When fabricating only green or red LEDs an EBL of AlGaN (Al content below 10%), GaN or InGaN (In content lower than n- and p-type InGaN layers) may be used,

A p-type InGaN top layer is further grown over the QW layer of the microLED structures. For blue LED, the p-layer may be p-GaN, or p-InGaN with only a few percent (<10% or <5%) In, with a thickness of 100-200 nm. For the green and red LEDs p-InGaN with an indium content of 10% and 18%, respectively, may be used. The p-type doping is accomplished using e.g., Mg at a level at least above 1×10¹⁹ cm⁻³. Rapid thermal annealing may be used to activate the Mg doping.

The contact spacer layer 51, seen in Figs 5B and 6B, can be a polymer. Preferably a dielectric spacer layer, such as PECVD SiOx, should be used together with CMP to expose the top c-plane of p-InGaN layer. Before the PECVD SiOx growth, a thin layer of ALD Al₂O₃ may be deposited first to protect the surface from being damaged by plasma at the beginning of SiOx deposition by PECVD and also to serve as surface passivation of the platelet surfaces.

Preferably, the n-type contacts to the base end of the InGaN platelets and the contacts to the p-type InGaN, may be processed on the platelet side of the epiwafer 10, as shown in Figs 8B and 9B, which allows for convenient bonding to the driver circuits, such as CMOS driver chips. In this context, the flat c-plane top surface of the microLED structures provides a suitable surface for bonding of the p-contacts.

Overall, the fabrication method for the semiconductor device for microLEDs described herein provides a robust and efficient approach to creating high-quality microLEDs with minimized defects in crystal formation and improved external quantum efficiency. The various steps and optional features of the method contribute to the formation of microLED structures with precise control over their shape, configuration, and emission properties, ensuring optimal performance of the resulting microLEDs in a wide range of applications.

The proposed solution offers a huge advantage over prior art solutions. In state-of-the-art LED growth, one color LED, either blue, green or red, can be made on one wafer (or one growth run). To fabricate full color microLED displays, mass transfer needs to be used to transfer sub-pixels of R, G, B microLEDs. This is a very challenging step, specifically not practical for the microLED below 10 µm. In contrast, the proposed solution provides RGB sub-pixels on the same wafer in one growth step. This way, each full RGB pixel, containing three R/G/B sub-pixels, can be directly bonded to the driving circuit, avoiding the usage of mass transfer. This provides monolithic integration of RGB platelet microLEDs by epitaxy, such as Metal-Organic Chemical Vapor Deposition (MOCVD).

## Claims

1. A semiconductor device (30), comprising:
an epiwafer (10);
a plurality of InGaN platelets (100), each InGaN platelet being monolithically grown on the epiwafer and configured with a top c-plane surface (110);
an upper mask layer (200) having mask apertures (220) over the InGaN platelets, wherein said mask apertures have a width which is smaller than said top c-plane surface;
a plurality of microLED structures (240) comprising quantum well, QW, layers (242), wherein each microLED structure is grown on the top c-plane surface in one of said mask apertures.

2. The semiconductor device of claim 1, wherein each microLED structure further comprises a top InGaN layer (243) grown on the respective QW layer.

3. The semiconductor device of claim 1 or 2, wherein a single mask aperture is configured over each InGaN platelet, wherein a single microLED is configured on each InGaN platelet.

4. The semiconductor device of any preceding claim, wherein a plurality of mask apertures (221, 222, 223) is configured over each InGaN platelet, wherein a plurality of microLED structures (230, 240, 250) is configured on each InGaN platelet.

5. The semiconductor device of claim 4, wherein three mask apertures are configured over each InGaN platelet, wherein respective microLED structures for red, green and blue emission are configured on each InGaN platelet.

6. The semiconductor device of any preceding claim, wherein the aperture width correlates with emission wavelength from the respective microLED structure.

7. The semiconductor device of any preceding claim, wherein the apertures are configured with increasing width for different emission wavelength of the respective microLED structure, in the order red-green-blue.

8. The semiconductor device of any preceding claim, wherein each microLED structure comprises an InGaN surface layer (241) grown in the mask aperture over the top c-plane, wherein the QW layer is grown on the InGaN surface layer.

9. The semiconductor device of claim 8, wherein the InGaN surface layer has decreasing indium concentration with increasing width of the aperture.

10. The semiconductor device of any preceding claim, wherein the epiwafer comprises a lower mask layer with mask openings in which the grown InGaN platelets are configured.

11. The semiconductor device of any preceding claim, wherein the top c-plane surface has a hexagonal footprint.

12. The semiconductor device of any preceding claim, wherein the mask aperture has a substantially circular footprint.

13. The semiconductor device of any preceding claim, wherein each microLED structure have a truncated pyramid shape terminating in a c-plane connector surface.

14. A microLED device (500), comprising:
a semiconductor device of any preceding claims; and
a driver circuit (54), connected by p-contacts to respective top portions of each microLED structure and by an n-contact to a base side of the epiwafer, for generating light emission from the respective microLED structure.

15. A method of fabricating a semiconductor structure, comprising:
forming InGaN platelets monolithically grown on an epiwafer, wherein each InGaN platelet has a top c-plane surface;
configuring an upper mask layer over the InGaN platelets;
forming mask apertures in the upper mask over the top c-plane surfaces, wherein said apertures have a width which is smaller than said top c-plane surface; and
growing, from each mask aperture, a microLED structure comprising a quantum well, QW, layer over the top c-plane surface.

## Patentansprüche

1. Halbleitervorrichtung (30), die Folgendes umfasst:
einen Epiwafer (10);
eine Vielzahl von InGaN-Plättchen (100), wobei jedes InGaN-Plättchen monolithisch auf dem Epiwafer gezüchtet wird und mit einer obersten c-Ebenen-Oberfläche (110) konfiguriert ist;
eine obere Maskenschicht (200), die Maskenöffnungen (220) über den InGaN-Plättchen aufweist, wobei die Maskenöffnungen eine Breite aufweisen, die kleiner als die oberste c-Ebenen-Oberfläche ist;
eine Vielzahl von MikroLED-Strukturen (240), die Quantentopf-, QW-, Schichten (242) umfassen, wobei jede MikroLED-Struktur auf der obersten c-Ebenen-Oberfläche in einer der Maskenöffnungen gezüchtet wird.

2. Halbleitervorrichtung nach Anspruch 1, wobei jede MikroLED-Struktur ferner eine auf der jeweiligen QW-Schicht gezüchtete, oberste InGaN-Schicht (243) umfasst.

3. Halbleitervorrichtung nach Anspruch 1 oder 2, wobei über jedem InGaN-Plättchen eine einzelne Maskenöffnung konfiguriert ist, wobei auf jedem InGaN-Plättchen eine einzelne MikroLED konfiguriert ist.

4. Halbleitervorrichtung nach einem der vorstehenden Ansprüche, wobei eine Vielzahl von Maskenöffnungen (221, 222, 223) über jedem InGaN-Plättchen konfiguriert ist, wobei eine Vielzahl von MikroLED-Strukturen (230, 240, 250) auf jedem InGaN-Plättchen konfiguriert ist.

5. Halbleitervorrichtung nach Anspruch 4, wobei drei Maskenöffnungen über jedem InGaN-Plättchen konfiguriert sind, wobei jeweilige MikroLED-Strukturen für rote, grüne und blaue Emission auf jedem InGaN-Plättchen konfiguriert sind.

6. Halbleitervorrichtung nach einem der vorstehenden Ansprüche, wobei die Öffnungsbreite mit der Emissionswellenlänge aus der jeweiligen MikroLED-Struktur korreliert.

7. Halbleitervorrichtung nach einem der vorstehenden Ansprüche, wobei die Öffnungen mit zunehmender Breite für unterschiedliche Emissionswellenlängen der jeweiligen MikroLED-Struktur in der Reihenfolge Rot-Grün-Blau konfiguriert sind.

8. Halbleitervorrichtung nach einem der vorstehenden Ansprüche, wobei jede MikroLED-Struktur eine in der Maskenöffnung über der obersten c-Ebene gezüchtete InGaN-Oberflächenschicht (241) umfasst, wobei die QW-Schicht auf der InGaN-Oberflächenschicht gezüchtet wird.

9. Halbleitervorrichtung nach Anspruch 8, wobei die InGaN-Oberflächenschicht mit zunehmender Breite der Öffnung eine abnehmende Indiumkonzentration aufweist.

10. Halbleitervorrichtung nach einem der vorstehenden Ansprüche, wobei der Epiwafer eine untere Maskenschicht mit Maskenöffnungen umfasst, in denen die gezüchteten InGaN-Plättchen konfiguriert sind.

11. Halbleitervorrichtung nach einem der vorstehenden Ansprüche, wobei die oberste c-Ebenen-Oberfläche eine hexagonale Grundfläche aufweist.

12. Halbleitervorrichtung nach einem der vorstehenden Ansprüche, wobei die Maskenöffnung eine im Wesentlichen kreisförmige Grundfläche aufweist.

13. Halbleitervorrichtung nach einem der vorstehenden Ansprüche, wobei jede MikroLED-Struktur eine abgestumpfte Pyramidenform aufweist, die in einer c-Ebenen-Verbinderoberfläche endet.

14. MikroLED-Vorrichtung (500), die Folgendes umfasst:
eine Halbleitervorrichtung nach einem der vorstehenden Ansprüche; und
eine Treiberschaltung (54), die über p-Kontakte mit den jeweiligen obersten Abschnitten jeder MikroLED-Struktur und über einen n-Kontakt mit einer Basisseite des Epiwafers verbunden ist, um eine Lichtemission aus der jeweiligen MikroLED-Struktur zu erzeugen.

15. Verfahren zum Herstellen einer Halbleiterstruktur, das Folgendes umfasst:
Bilden von monolithisch auf einem Epiwafer gezüchteten InGaN-Plättchen, wobei jedes InGaN-Plättchen eine oberste c-Ebenen-Oberfläche aufweist;
Konfigurieren einer oberen Maskenschicht über den InGaN-Plättchen;
Bilden von Maskenöffnungen in der oberen Maske über den obersten c-Ebenen-Oberflächen, wobei die Öffnungen eine Breite aufweisen, die kleiner als die oberste c-Ebenen-Oberfläche ist; und
Züchten einer MikroLED-Struktur, die eine Quantentopf-, QW-, Schicht über der obersten c-Ebenen-Oberfläche umfasst, aus jeder Maskenöffnung.

## Revendications

1. Dispositif semi-conducteur (30), comprenant :
une tranche épitaxiée (10) ;
une pluralité de plaquettes d'InGaN (100), chaque plaquette d'InGaN étant développée de manière monolithique sur la tranche épitaxiée et configurée avec une surface c-plane supérieure (110) ;
une couche de masque supérieure (200) présentant des ouvertures de masque (220) au-dessus des plaquettes d'InGaN, dans lequel lesdites ouvertures de masque présentent une largeur inférieure à celle de ladite surface c-plane supérieure ;
une pluralité de structures microLED (240) comprenant des couches à puits quantiques, QW, (242) dans lesquelles chaque structure microLED est développée sur la surface c-plane supérieure dans l'une desdites ouvertures de masque.

2. Dispositif à semi-conducteur selon la revendication 1, dans lequel chaque structure microLED comprend en outre une couche d'InGaN supérieure (243) développée sur la couche QW respective.

3. Dispositif à semi-conducteur selon la revendication 1 ou 2, dans lequel une seule ouverture de masque est configurée au-dessus de chaque plaquette d'InGaN, dans lequel une seule microLED est configurée au-dessus de chaque plaquette d'InGaN.

4. Dispositif à semi-conducteur selon toute revendication précédente, dans lequel une pluralité d'ouvertures de masque (221, 222, 223) est configurée au-dessus de chaque plaquette d'InGaN, dans lequel une pluralité de structures de microLED (230, 240, 250) est configurée sur chaque plaquette d'InGaN.

5. Dispositif à semi-conducteur selon la revendication 4, dans lequel trois ouvertures de masque sont configurées au-dessus de chaque plaquette d'InGaN, dans lequel des structures de microLED respectives pour l'émission rouge, verte et bleue sont configurées sur chaque plaquette d'InGaN.

6. Dispositif à semi-conducteur selon toute revendication précédente, dans lequel la largeur d'ouverture est en corrélation avec la longueur d'onde d'émission de la structure de microLED respective.

7. Dispositif à semi-conducteur selon toute revendication précédente, dans lequel les ouvertures sont configurées avec une largeur croissante pour différentes longueurs d'onde d'émission de la structure de microLED respective, dans l'ordre rouge-vert-bleu.

8. Dispositif à semi-conducteur selon toute revendication précédente, dans lequel chaque structure de microLED comprend une couche de surface d'InGaN (241) développée dans l'ouverture de masque au-dessus du c-plane supérieur, dans lequel la couche QW est développée sur la couche de surface d'InGaN.

9. Dispositif à semi-conducteur selon la revendication 8, dans lequel la couche de surface d'InGaN présente une concentration en indium décroissante à mesure que la largeur de l'ouverture augmente.

10. Dispositif à semi-conducteur selon toute revendication précédente, dans lequel la tranche épitaxiée comprend une couche de masque inférieure avec des ouvertures de masque dans lesquelles sont configurées les plaquettes d'InGaN développées.

11. Dispositif à semi-conducteur selon toute revendication précédente, dans lequel la surface c-plane supérieure présente une empreinte hexagonale.

12. Dispositif à semi-conducteur selon toute revendication précédente, dans lequel l'ouverture de masque présente une empreinte sensiblement circulaire.

13. Dispositif à semi-conducteur selon toute revendication précédente, dans lequel chaque structure de microLED présente une forme de pyramide tronquée se terminant par une surface de connecteur en c-plane.

14. Dispositif microLED (500), comprenant :
un dispositif à semi-conducteur selon toute revendication précédente ; et
un circuit pilote (54), connecté par p-contacts aux parties supérieures respectives de chaque structure de microLED et par un n-contact à un côté de base de la tranche épitaxiée, pour la génération d'une émission lumineuse à partir de la structure de microLED respective.

15. Procédé de fabrication d'une structure de semi-conducteur, comprenant :
la formation de plaquettes d'InGaN développées de manière monolithique sur une tranche épitaxiée, dans laquelle chaque plaquette d'InGaN présente une surface c-plane supérieure ;
la configuration d'une couche de masque supérieure sur les plaquettes d'InGaN ;
la formation d'ouvertures dans le masque supérieur au-dessus des surfaces c-plane supérieures, dans laquelle lesdites ouvertures présentent une largeur inférieure à celle de ladite surface c-plane supérieure ; et
le développement, à partir de chaque ouverture de masque, d'une structure de microLED comprenant une couche à puits quantique, QW, au-dessus de la surface c-plane supérieure.
